# FASCICULE DE BREVET EUROPEEN

(11) **EP 2 264 596 B1**
(45) Date de publication et mention de la délivrance du brevet: **04.01.2012**
(21) Numéro de dépôt: 10163778.3
(22) Date de dépôt: 25.05.2010
(51) Int. Cl.: G06F 11/10, G11C 7/24

(54) **Procédé de détection d'une attaque par injection de faute d'un dispositif de mémoire, et dispositif de mémoire correspondant.**
Verfahren zur Erkennung eines Angriffs durch Fehlerinjektion in eine Speichervorrichtung und entsprechende Speichervorrichtung
Method for detecting a fault-injection attack of a memory device and corresponding memory device

(30) Priorité: 16.06.2009 FR 0954025
(43) Date de publication de la demande: 22.12.2010
(73) Titulaire: STMicroelectronics (Rousset) SAS, 13790 Rousset (FR)
(72) Inventeur: Lisart, Mathieu, 13100 Aix en Provence (FR); Mercier, Julien, 13590 Meyreuil (FR)
(74) Mandataire: Zapalowicz, Francis

(56) Documents cités:
- US-A- 3 286 235
- US-A1- 2003 217 323
- US-A1- 2005 229 060
- US-A1- 2008 151 669
- US-A1- 2009 113 546

## Description

L'invention concerne, de façon générale les circuits électroniques, et plus particulièrement la détection d'une attaque par injection de faute d'un dispositif de mémoire.

L'invention s'applique avantageusement mais non limitativement aux cartes à puce et à la protection des données confidentielles qu'elles contiennent.

Parmi les attaques possibles effectuées par des fraudeurs pour extraire des données confidentielles d'une mémoire, par exemple une mémoire protégée d'une carte à puce, on peut citer les attaques dites par injection de faute (DFA ou « Differential Fault Analysis ») qui prévoient de perturber le fonctionnement et/ou le contenu de la mémoire, par exemple au moyen d'un rayonnement (laser, infrarouge, rayons X, etc.).

Il est donc particulièrement utile d'être capable de détecter une telle attaque par injection de faute. Une fois l'attaque détectée, de nombreuses solutions existent selon les applications pour soit bloquer le composant, soit interdire la donnée des données sensibles, soit réinitialiser le composant, ...

Pour les architectures de mémoire classiques, par exemple celles de type bit à bit dans lesquelles chaque bit stocké peut être lu individuellement, il existe une possibilité de détection d'une telle attaque basée sur un contrôle de parité des bits lus lors d'une opération de lecture.

Cependant, une telle solution ne permet pas, dans certains cas, de détecter une attaque par injection de faute alors que cette dernière attaque a effectivement eu lieu.

Selon un mode de mise en oeuvre et de réalisation, il est proposé un procédé de détection d'une attaque par injection de faute d'un dispositif de mémoire et un dispositif de mémoire correspondant, offrant une détection plus fiable d'une attaque par injection de faute.

US 3,286,235 décrit un système de stockage d'information, dans lequel des informatisons de transaction de stock devant être écrites dans une ou plusieurs mémoires cycliques sont transmises sous forme de messages. La précision de transmission des messages est contrôlée par un système de contrôle de parité d'un type spécifique.

Selon un aspect, il est proposé un procédé de détection d'une attaque par injection de faute d'un dispositif de mémoire comportant au moins un groupe de cellules-mémoires destinées à stocker au moins un bloc de bits comportant des bits de données et m bits de parité ; ladite détection comprend, lors de la lecture d'un bloc, une lecture de chaque bit du bloc contenu dans la cellule-mémoire correspondante et un contrôle de parité effectué à partir de la valeur lue de chaque bit de données et de la valeur lue de chaque bit de parité.

Selon une caractéristique générale de cet aspect, le procédé comprend :
- une insertion de cellules-mémoires de référence entre certaines au moins des cellules-mémoires dudit groupe, de façon à créer des paquets séparés de m cellules-mémoires,
- un stockage dans chaque cellule-mémoire de référence, d'un bit de référence programmé à une valeur de référence susceptible d'être modifiée lors d'une attaque par injection de faute,
- un stockage, dans chaque paquet de m cellules-mémoires, de m bits du bloc associés, lorsque m est supérieure à 1, à des parités différentes, et
- ladite détection comprend en outre, lors de la lecture dudit bloc, un contrôle de la valeur de chaque bit de référence.

Ainsi, par exemple, insérer des bits de référence à des endroits choisis du plan-mémoire et stocker entre ces bits de référence des bits du bloc devant être lu associés à des parités différentes, permet de détecter une attaque par injection de faute, même lorsqu'un faisceau laser est suffisamment large pour éclairer deux cellules-mémoires susceptibles de contenir deux bits de même parité car, dans ce cas-là, le faisceau laser touchera également un bit de référence en faisant basculer sa valeur, ce qui provoquera un signal de détection d'attaque.

Par ailleurs, un bit associé à une parité donnée peut être soit un bit de donnée ayant ladite parité ou bien le bit de parité lui-même relatif à cette parité.

Bien que plusieurs emplacements soient possibles pour l'insertion des cellules-mémoires de référence, compte tenu en particulier de la correspondance entre les rangs des bits et les cellules-mémoires destinées à stocker ces bits, il est particulièrement simple de prévoir une insertion d'une cellule-mémoire de référence toutes les m cellules-mémo ires.

Selon un mode de mise en oeuvre, lorsque le dispositif de mémoire comprend plusieurs groupes de cellules-mémoires destinés à stocker respectivement plusieurs blocs de bits, chaque bloc de bits ayant le même nombre de bits de données et m bits de parité, et toutes les cellules-mémoires destinées à stocker les bits de même rang des différents blocs étant regroupées au sein d'une même zone du plan-mémoire, on insère de préférence les cellules-mémoires de référence entre certaines au moins desdites zones.

Selon un autre aspect, il est proposé un dispositif de mémoire comprenant un plan-mémoire comportant au moins un groupe de cellules-mémoires destinées à stocker au moins un bloc de bits comportant des bits de données et m bits de parité, et des moyens de détection d'une attaque par injection de faute comportant des moyens de lecture configurés pour lire chaque bit d'un bloc et des premiers moyens de contrôle configurés pour, lors de la lecture d'un bloc, effectuer un contrôle de parité à partir de la valeur lue de chaque bit de donnée et de la valeur lue de chaque bit de parité ;
selon une caractéristique générale de cet aspect, le plan-mémoire comprend des cellules-mémoire de référence disposées entre certaines au moins des cellules-mémoires dudit groupe de façon à créer des paquets séparés de m cellules-mémoire, chaque cellule-mémoire de référence stockant un bit de référence programmé à une valeur de référence susceptible d'être modifiée lors d'une attaque par injection de faute et chaque paquet de m cellules-mémoires étant destinées à stocker m bits du bloc associés, lorsque m est supérieur à 1, à des parités différentes, et les moyens de détection comprennent en outre des deuxièmes moyens de contrôle configurés pour effectuer lors de la lecture dudit bloc, un contrôle de la valeur de chaque bit de référence.

Selon un mode de réalisation, une cellule-mémoire de référence est disposée toutes les m cellules-mémoires.

Selon un mode de réalisation, dans lequel le plan-mémoire comprend plusieurs groupes de cellules-mémoires destinés à stocker respectivement plusieurs blocs de bits, chaque bloc de bits ayant le même nombre de bits de données et m bits de parité, toutes les cellules-mémoires destinées à stocker les bits de même rang des différents blocs étant regroupées au sein d'une même zone du plan-mémoire, les cellules-mémoires de référence sont disposées entre certaines au moins desdites zones.

Selon un autre aspect, il est proposé un circuit intégré incorporant un dispositif de mémoire tel que défini ci-avant.

Selon encore un autre aspect, il est proposé une carte à puce comprenant un circuit intégré tel que défini ci-avant.

D'autres caractéristiques et avantages de l'invention apparaîtront à l'examen de la description détaillée de modes de mise en oeuvre et de réalisation, nullement limitatifs, et des dessins annexés sur lesquels :
- la figure 1 illustre schématiquement un exemple de dispositif de mémoire selon l'art antérieur ;
- la figure 2 illustre schématiquement un exemple de réalisation d'un dispositif de mémoire selon l'invention ;
- la figure 3 illustre schématiquement un exemple de mise en oeuvre d'un procédé de détection d'attaque selon l'invention ;
- les figures 4 à 7 illustrent schématiquement d'autres configurations possibles d'un dispositif de mémoire selon l'invention ;
- la figure 8 illustre schématiquement plus en détails encore un autre exemple de réalisation d'un dispositif de mémoire selon l'invention ; et
- les figures 9 à 10 illustrent schématiquement des exemples d'autres aspects de l'invention.

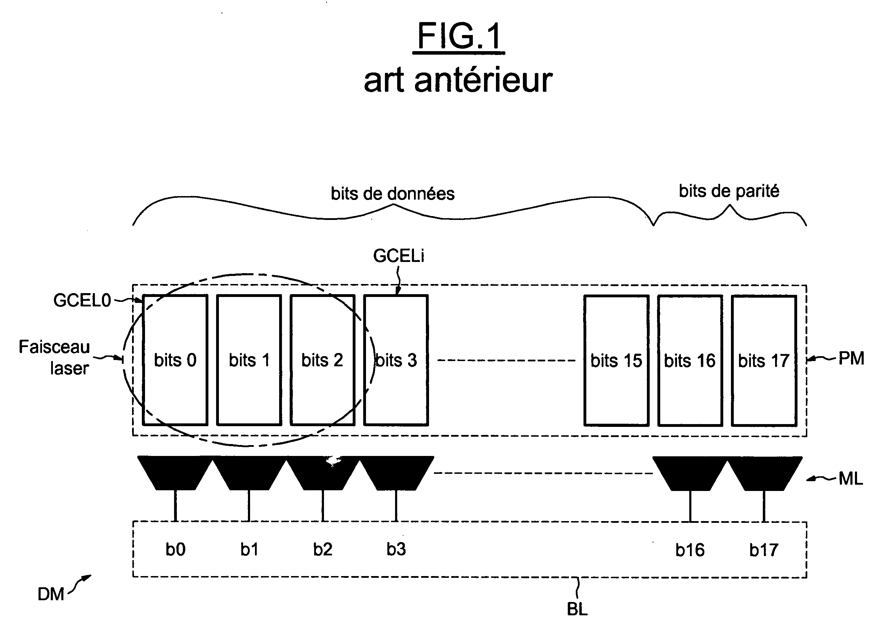

Sur la figure 1, la référence DM désigne un dispositif de mémoire classique dont le plan-mémoire PM comporte des ensembles de cellules-mémoires GCELi. Toutes les cellules-mémoires d'un même ensemble de cellules-mémoires sont destinées à stocker les bits de même rang des différents blocs de bits BL devant être stockés dans le plan-mémoire.

Plus précisément, dans l'exemple décrit ici, un bloc de bits BL devant être stocké dans le plan-mémoire comporte des bits de données, en l'espèce seize (de rang 0 à 15), et des bits de parité, en l'espèce deux, de rang 16 et 17.

Et, pour un bloc donné BL, la cellule-mémoire CEL0 est destinée à stocker le bit b0 de rang 0, la cellule-mémoire CEL1 est destinée à stocker le bit b1 de rang 1 et plus généralement, la cellule-mémoire CELi est destinée à stocker le bit bi de rang i. Le groupe de cellules-mémoires CELi est donc destiné à stocker le bloc BL.

Le dispositif de mémoire présente ici une architecture bit à bit, c'est-à-dire que lors de la lecture d'un bloc BL, tous les bits du bloc peuvent être lus individuellement.

A cet égard, il est prévu de façon classique des moyens de lecture ML permettant de sélectionner le groupe de cellules-mémoires contenant un bloc BL afin de lire les bits b0-b17 de ce bloc BL.

Lorsqu'un faisceau laser touche (éclaire) une cellule-mémoire contenant un bit, celui-ci peut changer de valeur et prendre une valeur de faute (« failure mode »), sauf s'il est déjà programmé à une valeur correspondant à sa valeur de faute. Par exemple, si la valeur de faute d'un bit est égale à 1, et que ce bit a une valeur programmée égale à 0, le fait qu'il soit impacté par un rayon laser va par conséquent le faire passer à la valeur 1. Par contre, s'il était déjà programmé à la valeur 1, il restera programmé à la valeur 1 lors de l'impact avec le faisceau laser.

Afin de détecter des attaques par injection de faute effectuées par exemple au moyen d'un faisceau laser, il est prévu d'effectuer un contrôle de parité.

Dans l'exemple décrit sur la figure 1, il est prévu deux bits de parité, à savoir un bit de parité paire (le bit b16) et un bit de parité impaire (le bit b17). La valeur du bit b16 est obtenue à partir de la somme des valeurs des bits de données pairs du bloc tandis que la valeur du bit b17 est obtenue à partir de la somme des valeurs des bits de données impairs du bloc.

Pour effectuer le contrôle de parité lors de la lecture du bloc BL, on détermine à partir de la valeur lue de chacun des bits pairs, un nouveau bit de parité dont on compare la valeur avec celle du bit de parité (le bit b16) lu. En cas de discordance, on conclut à une attaque par injection de faute.

On effectue la même opération pour les bits impairs.

Cela étant, il est possible dans certains cas que ce contrôle de parité conduise à la conclusion d'une absence d'attaque alors qu'en fait une telle attaque a eu effectivement lieu.

Plus précisément, on suppose, comme illustré sur la figure 1, que le faisceau laser illumine les bits de rangs 0,1 et 2. On suppose également que lors de cette illumination, le bit b0 et le bit b2 du bloc ont changé de valeur, et que le bit impair b1 n'a pas changé de valeur lors de cette illumination car sa valeur correspondait déjà à une valeur de faute.

Dans un tel cas, le contrôle de parité sur les bits impairs ne donnera aucune indication de détection d'attaque. De même, puisque deux bits pairs ont changé de valeur, le contrôle de parité sur les bits pairs conduira également à la conclusion d'une absence d'attaque.

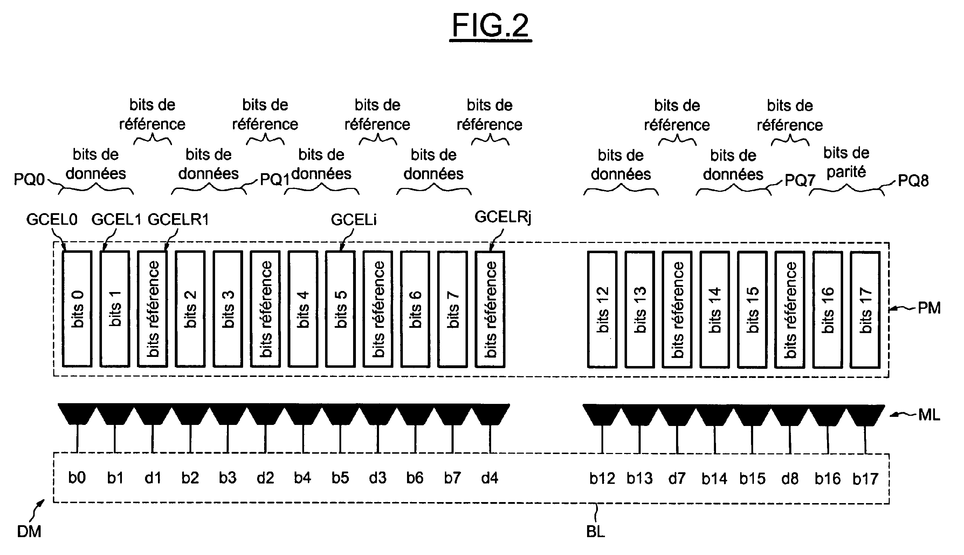

La figure 2 illustre un exemple de réalisation d'un dispositif de mémoire permettant en particulier de remédier à cet inconvénient.

Plus précisément, dans l'exemple décrit, on suppose toujours que chaque bloc devant être stocké dans le plan-mémoire PM du dispositif DM comporte n bits de données et m bits de parité, avec ici n=16 et m=2. Dans le cas général m est supérieur à 0 et inférieur ou égale à n. Dans l'architecture présentée ici, toutes les cellules-mémoires CELi destinées à stocker les bits bi de rang i des différents blocs sont regroupées au sein d'ensembles de cellules GCELi.

Et, au sein de ces différents ensembles, chaque groupe de cellules-mémoires CEL0-CEL17 est destiné à stocker un bloc BL de 18 bits b0-b17.

Dans l'exemple décrit ici, les bits de données d'un bloc sont les bits de rang 0 à 15 et sont stockés dans les cellules-mémoires CELO-CEL 15 tandis que les deux bits de parité sont les bits de rangs 16 et 17 qui sont respectivement stockés dans les cellules-mémoires CEL16 et CEL17.

Si l'on raisonne maintenant au niveau d'un groupe de cellules-mémoires CEL0-CEL17 destinées à stocker un bloc BL, on insère entre certaines au moins des cellules-mémoires de ce groupe d'autres cellules-mémoires, identiques aux cellules-mémoires du groupe, et que l'on nomme ici cellules-mémoires de référence, de façon à créer des paquets séparés de m cellules-mémoires.

Dans le cas présent, m est égal à 2. On crée donc des paquets de deux cellules-mémoires. Plus précisément, le paquet PQ0 est formé des cellules-mémoires CEL0 et CEL1 tandis que le paquet PQ1 est formé des cellules-mémoires CEL2 et CEL3, ...et le paquet PQ7 est formé des cellules-mémoires CEL 14 et CEL 15 tandis que le dernier paquet, à savoir le paquet PQ8, est formé des cellules-mémoires CEL16 et CEL17.

Chaque cellule de référence CELRj contient un bit de référence dj qui est programmé à une valeur de référence susceptible d'être modifiée lors d'une attaque par injection de faute. En d'autres termes, si la valeur de faute d'un bit est égale à 1, on programmera initialement chaque bit de référence à la valeur 0, de sorte que l'illumination de ce bit par le faisceau laser provoque le changement de sa valeur en la valeur logique 1.

Par ailleurs, on stocke dans chaque paquet m bits (ici deux bits) du bloc BL associés à des parités différentes.

Un bit associé à une parité donnée peut être un bit de donnée ayant ladite parité ou bien le bit de parité correspondant. Ainsi, un bit associé à une parité paire peut être un bit de donnée pair ou bien le bit de parité paire. De même, un bit associé à une parité impaire peut être un bit de donnée impair ou bien le bit de parité impaire.

Et, on voit sur la figure 2 que chacun des paquets PQ0-PQ7 contient un bit impair et un bit pair tandis que le paquet PQ8 contient le bit de parité paire et le bit de parité impaire.

Cela étant, il aurait été tout à fait possible que le bit de parité paire de chaque bloc soit logé, par exemple, dans le bit de rang 2 du paquet 1 et le bit de parité impaire soit logé à la place du bit de rang 5. Dans ce cas, les bits de rang 2 et de rang 5 seraient logés dans le paquet PQ8.

Plus généralement, la correspondance entre le rang d'un bit du bloc et le rang d'une cellule-mémoire destinée à stocker ce bit est sans importance, pour autant que les m cellules-mémoires d'un paquet stockent m bits associés à des parités différentes.

En cas d'une attaque par injection de faute, par exemple à l'aide d'un faisceau laser, si le faisceau laser touche par exemple uniquement la cellule CEL0 et change ainsi la valeur du bit b0, cette attaque sera détectée par le contrôle de parité paire.

Il en est de même si le faisceau laser illumine uniquement le bit de rang b1 par exemple, et change sa valeur. L'attaque sera détectée par le contrôle de parité impaire.

Si le faisceau laser illumine simultanément les deux bits b0 et b1, les contrôles de parités paire et impaire détecteront également cette attaque.

Et, si le faisceau laser est encore plus large pour illuminer tous les bits b0, b1, d1 et b2, il en résultera forcément un changement de la valeur de référence du bit de référence d1, ce qui permettra de détecter l'attaque, et ce même si les deux bits pairs b0 et b2 ont leur valeur simultanément changée.

Bien entendu, si le faisceau laser illumine uniquement le bit impair b1 sans modifier sa valeur, le contrôle de parité impaire ne détectera pas cette attaque. Mais, de toute façon, cela est sans importance car l'attaque n'aura pas modifié la valeur réelle du bit b1.

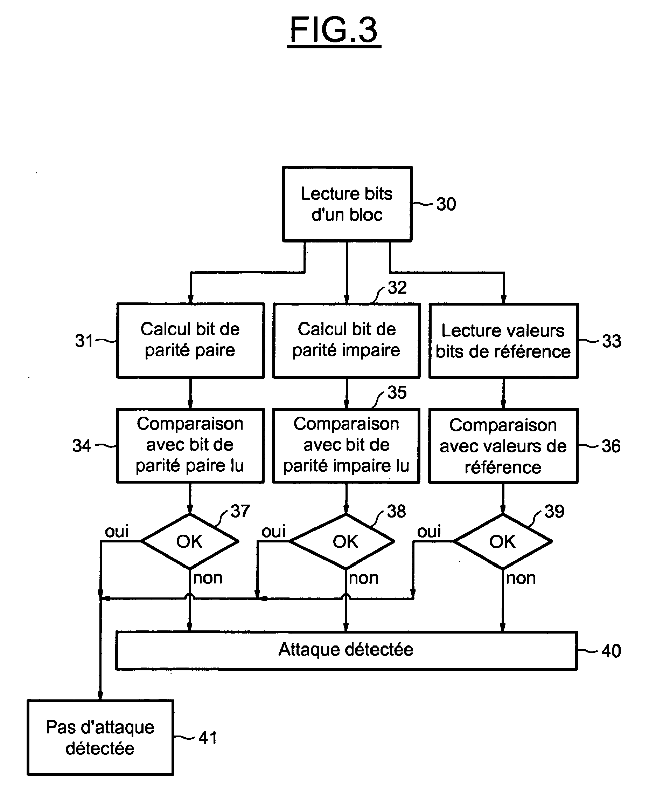

La figure 3 résume les principales étapes d'un mode de mise en oeuvre permettant la détection d'une attaque par injection de faute.

Plus précisément, lors de la lecture d'un bloc BL, on lit tous les bits du bloc (étape 30).

On effectue un calcul de bit de parité paire (étape 31) à partir la valeur de tous les bits pairs lus.

On effectue également un calcul de bit de parité impaire (étape 32) à partie des valeurs des bits impairs lus.

On effectue également une lecture des valeurs des bits de référence (étape 33).

On effectue ensuite un contrôle de parité paire (étape 34) qui comporte la comparaison du bit de parité paire calculé avec le bit de parité paire lu. On effectue de même un contrôle de parité impaire (étape 35) comprenant la comparaison de la valeur du bit de parité impaire calculé avec le bit de parité impaire lu.

On effectue également une comparaison des valeurs lues des bits de référence avec les valeurs de référence de ces bits (étape 36).

Dans le cas où toutes ces comparaisons donnent des résultats corrects (étapes 37, 38 et 39), il n'y a pas d'attaque détectée (étape 41).

Par contre, si l'une au moins de ces comparaisons 37, 38 et 39 donne une valeur logique fausse, alors il y a détection d'une attaque par injection de faute (étape 40).

Dans l'exemple illustré sur la figure 2, les cellules-mémoires de référence CELRj ont été insérées toutes les m cellules-mémoires, en l'espèce toutes les deux cellules-mémoires.

Le nombre de bits de référence est alors égal au rapport n/m où n est le nombre de bits de données et m le nombre de bits de parité. Dans l'exemple de la figure 2, le nombre de bits de référence est donc égal à 8.

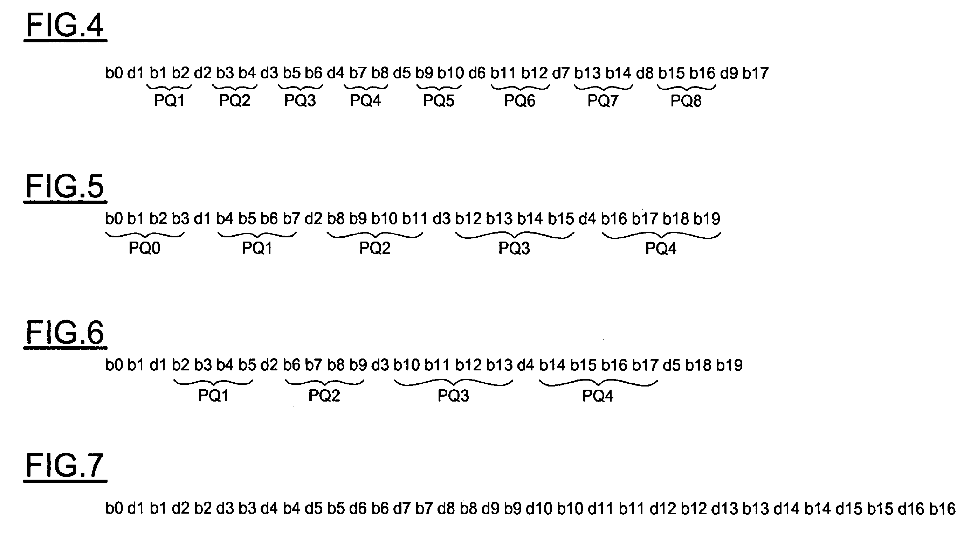

Mais, d'autres configurations sont possibles, comme celles par exemple illustrées sur les figures 4 à 7.

Sur ces figures 4 à 7, à des fins de simplification, on n'a représenté que les bits de données et de parité d'un bloc, ainsi que les bits de référence insérés entre certains au moins de ces bits. Et sur ces figures, ces bits correspondent également aux cellules-mémoires qui les stockent.

Sur la figure 4, on suppose là encore que le bloc comporte seize bits de données de rangs 1 à 15 et deux bits de parité, à savoir les bits b16 et b17.

Dans cet exemple, on insère également tous les deux bits du bloc (ou toutes les deux cellules-mémoires) un bit de référence dj (correspondant à une cellule-mémoire de référence). Cela étant, au lieu de commencer après le bit b1 comme dans le cas de la figure 2, on commence après le bit b0.

Dans ce cas, on insère donc 1+n/m bits de référence soit, dans le cas présent, 9 bits de référence d1-d9.

On voit donc que là encore, les paquets séparés de deux cellules-mémoires PQ1-PQ8 contiennent chacun deux bits associés à des parités différentes. Plus précisément, les paquets PQ1 à PQ7 contiennent chacun un bit de donnée pair et un bit de donnée impair, tandis que le paquet PQ8 contient le bit de donnée impair de rang 15 (b15) ainsi que le bit de parité paire de rang 16 (b16).

Par ailleurs, les bits de rang 0 et de rang 18, à savoir les bits b0 et b17, stockés dans des cellules-mémoires situées à l'opposé l'une de l'autre dans le plan-mémoire, forment un neuvième paquet de deux bits du bloc BL associés à des parités différentes. En effet, le bit b0 est le premier bit pair du bloc et le bit b17 est le bit de parité impaire.

Bien entendu, l'ordre des bits et/ou le rang des bits dans chaque paquet pourraient être modifiés, pour autant que dans chaque paquet soient stockés deux bits associés à des parités différentes.

Sur la figure 5, on suppose qu'un bloc BL comporte seize bits de données (n=16) b0-b15 et quatre bits de parité b16, b17, b18, b19 (m=4).

La valeur du bit de parité b16 est obtenue à partir de la somme des valeurs des bits de rang 4k avec k variant de 0 à 3.

La valeur du bit de parité b17 est obtenue à partir de la somme des valeurs des bits de rang 4k+1 avec k variant de 0 à 3.

La valeur du bit de parité b18 est obtenue à partir de la somme des valeurs des bits de rang 4k+2 avec k variant de 0 à 3.

La valeur du bit de parité b19 est obtenue à partir de la somme des valeurs des bits de rang 4k+3 avec k variant de 0 à 3.

Là encore, on insère une cellule-mémoire de référence contenant un bit de référence dj toutes les quatre cellules-mémoires, c'est-à-dire tous les quatre bits du bloc. Dans l'exemple de la figure 5, on commence cette insertion après le bit b3 de rang 3, ce qui conduit à l'insertion de quatre bits de référence (n/m=16/4=4).

Dans chacun des paquets PQ0, PQ1, PQ2, PQ3 et PQ4 sont stockés des bits associés à des parités différentes. Dans l'exemple de la figure 5, le paquet PQ4 comporte tous les bits de parité. Cela étant, il aurait été possible de répartir ces bits de parité au sein des autres paquets PQ0, PQ1, PQ2 et PQ3 pour autant que les bits restants de chacun de ces paquets soient associés à des parités différentes de la parité du bit de parité qui y est stocké.

Sur la figure 6, on a là encore seize bits de données et quatre bits de parité (n=16, m=4). Cependant, l'insertion des bits de référence dj débute après le bit b1 de rang 1. Ceci conduit à l'insertion de cinq (1+n/m) bits de référence d1-d5. Les paquets PQ1, PQ2 et PQ3 comportent chacun quatre bits de données de parités différentes tandis que le paquet PQ4 comporte deux bits de données (les bits b14 et b15) de parités différentes et les deux bits de parité b16 et b17 associés aux deux autres parités.

Enfin, les cellules-mémoires contenant respectivement les bits b0, b1, b18 et b19 forment un cinquième paquet.

Sur la figure 7, on considère que le bloc possède seize bits de données b0-b15 (n=16) et un bit de parité b16 (m=1) dont la valeur est obtenue à partir de la somme des valeurs de tous les bits de données du bloc.

Dans ce cas, on insère un bit de référence dj entre tous les bits du bloc, c'est-à-dire qu'on place une cellule-mémoire de référence entre toutes les cellules-mémoires destinées à contenir respectivement les bits de données et de parité du bloc.

Dans cet exemple, on a encore constitué ici des paquets séparés d'une cellule-mémoire contenant un bit du bloc.

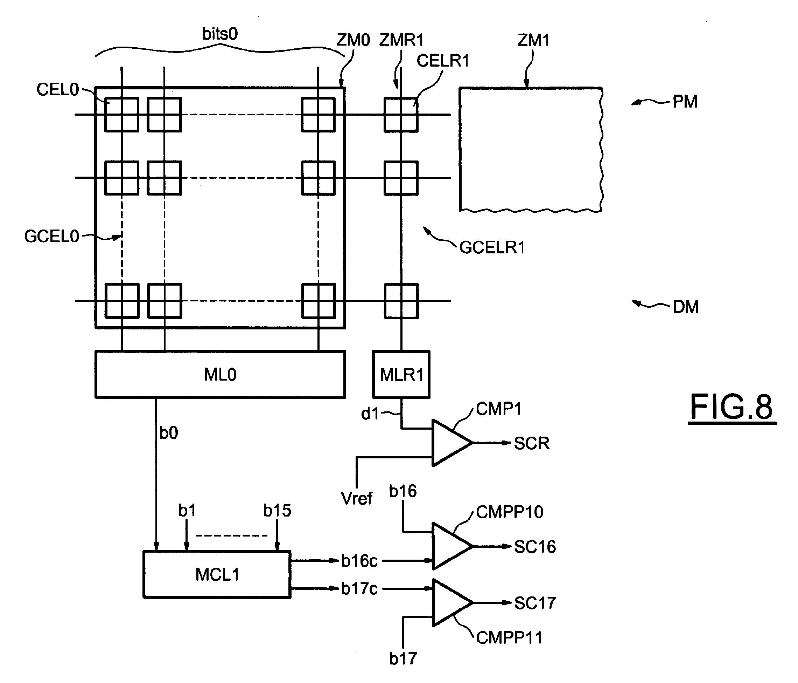

On se réfère maintenant plus particulièrement à la figure 8 pour illustrer plus en détails un exemple de réalisation de moyens de détection d'attaque du dispositif de mémoire DM.

Dans cet exemple, et comme explicité ci-avant, les cellules-mémoires, par exemple les cellules CEL0, destinées à stocker les bits b0 de rang 0 des différents blocs, sont regroupées pour former un ensemble ou matrice de cellules-mémoires GCEL0. Cet ensemble GCELO est situé au sein d'une zone ZM0 du plan-mémoire. Des moyens de lecture sont associés à chaque zone ZMk du plan-mémoire pour permettre de sélectionner la cellule CEL0 contenant le bit b0 du bloc que l'on souhaite effectivement lire. Ces moyens ML0 sont de structure classique et connue en soi et comportent notamment un décodeur colonnes, des moyens d'amplification de lecture. Par ailleurs, le dispositif de mémoire DM comporte également un décodeur lignes, de structure classique et connue en soi, qui permet de sélectionner la ligne voulue de cellules-mémoires dans le plan-mémoire.

La sélection d'une ligne et d'une colonne permet donc de délivrer en sortie des moyens ML0 le bit b0 de rang 0 du bloc que l'on souhaite lire.

Les différents moyens MLk associés aux différents ensembles GCELk délivrent donc respectivement les bits b0-b15 du bloc. Ces bits de données sont traités dans des moyens de calcul MCL1, de structure classique et connue en soi, qui déterminent la somme des valeurs des bits pairs et la somme des valeurs des bits impairs pour déterminer les bits de parité paire et impaire calculés respectivement référencés b16c et b17c.

Le bit b 16c est ensuite comparé dans un comparateur CMPP10 avec le bit de parité paire b16 extrait du plan-mémoire.

De même, le bit de parité calculé b17c est comparé dans un comparateur CMPP11 avec le bit de parité impaire b17 extrait du plan-mémoire.

Les comparateurs CMPP 10 et CMPP11 fournissent respectivement des signaux SC16 et SC17 représentatifs d'une comparaison vraie ou fausse, c'est-à-dire d'une non détection d'attaque ou bien d'une détection d'attaque.

Par ailleurs, les cellules-mémoires de référence sont disposées entre les différentes zones ZMk du plan-mémoire.

Plus précisément, comme illustré sur la figure 8, on prévoit dans la zone ZMR1 située entre la zone ZM0 et la zone ZM1 contenant les cellules-mémoires destinées à stocker les bits de rang 1 de chaque bloc, une colonne de cellules-mémoires de référence. Cet ensemble GCELR1 de cellules-mémoires de référence CELR1 est relié à des moyens de lecture MLR1 de structure analogue à celle des moyens ML0, mais sans la présence du décodeur colonnes, puisque l'ensemble de ces cellules-mémoires de référence est disposé sur une seule et même colonne.

Bien entendu, il y a une cellule-mémoire de référence par ligne, qui sera en conséquence sélectionnée par le décodeur lignes.

Le bit de référence d1 extrait de la cellule de référence CELR1 sélectionnée va être comparé dans un comparateur CMP1 avec la valeur de référence de façon à délivrer un signal de comparaison SCR représentatif d'une valeur vraie ou fausse de la comparaison, et par conséquent représentatif d'une non détection d'attaque ou d'une détection d'attaque.

Les moyens CMP1 forment donc ici des deuxièmes moyens de contrôle configurés pour effectuer un contrôle de la valeur du bit de référence correspondant.

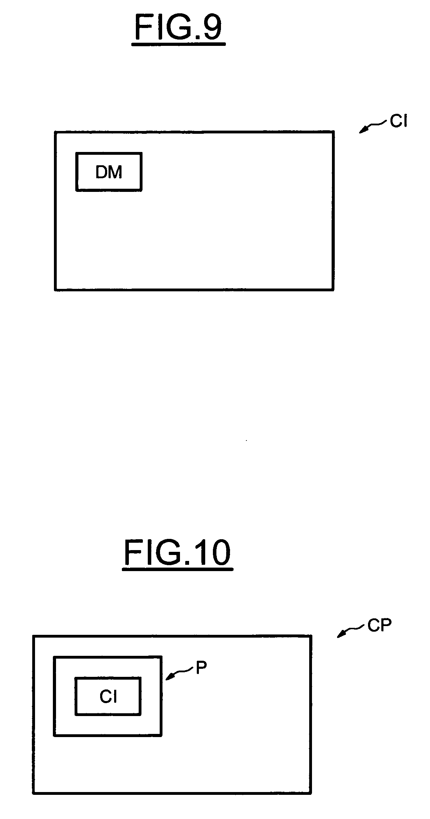

Le dispositif de mémoire DM peut être avantageusement réalisé de façon intégrée et inséré au sein d'un circuit intégré CI comme illustré très schématiquement sur la figure 9.

Un tel circuit intégré CI peut faire partie de la puce P d'une carte à puce CP (figure 10).

L'invention permet donc en particulier d'améliorer de façon simple la fiabilité de détection d'une attaque d'une mémoire par injection de fautes et peut s'appliquer à tout type de mémoire à architecture bit à bit, telle que par exemple des mémoires ROM, RAM, FLASH, ...

## Revendications

1. Procédé de détection d'une attaque par injection de faute d'un dispositif de mémoire comportant au moins un groupe de cellules-mémoires destinées à stocker au moins un bloc de bits comportant des bits de données et m bits de parité, procédé dans lequel ladite détection comprend, lors de la lecture d'un bloc, une lecture (30) de chaque bit du bloc contenu dans la cellule-mémoire correspondante et un contrôle de parité (37, 38) effectué à partir de la valeur lue de chaque bit de donnée et de la valeur lue de chaque bit de parité, **caractérisé en ce que** le procédé comprend une insertion de cellules-mémoires de référence (CELR1) entre certaines au moins des cellules-mémoires (CELi) dudit groupe de façon à créer des paquets séparés de m cellules-mémoires, un stockage dans chaque cellule-mémoire de référence d'un bit de référence (dj) programmé à une valeur de référence susceptible d'être modifiée lors d'une attaque par injection de faute et un stockage, dans chaque paquet de m cellules-mémoires, de m bits du bloc associés, lorsque m est supérieur à 1, à des parités différentes, et ladite détection comprend en outre lors de la lecture dudit bloc, un contrôle (39) de la valeur de chaque bit de référence.

2. Procédé selon la revendication 1, dans lequel on insère une cellule-mémoire de référence (CELRj) toutes les m cellules-mémoires.

3. Procédé selon l'une des revendications précédentes, dans lequel le dispositif de mémoire comprend plusieurs groupes de cellules-mémoires destinés à stocker respectivement plusieurs bloc de bits, chaque bloc (BL) de bits ayant le même nombre de bits de données et m bits de parité, toutes les cellules-mémoires (GCEL0) destinées à stocker les bits de même rang des différents blocs étant regroupées au sein d'une même zone (ZM0) du plan-mémoire, et on insère les cellules-mémoires de référence (CELR1) entre certaines au moins desdites zones.

4. Dispositif de mémoire comprenant un plan-mémoire (PM) comportant au moins un groupe de cellules-mémoires destinées à stocker au moins un bloc de bits (BL) comportant des bits de données et m bits de parité, et des moyens de détection d'une attaque par injection de faute comportant des moyens de lecture (ML) configurés pour lire chaque bit d'un bloc et des premiers moyens de contrôle (MCL1, CMPP10, CMPP11) configurés pour, lors de la lecture d'un bloc, effectuer un contrôle de parité à partir de la valeur lue de chaque bit de donnée et de la valeur lue de chaque bit de parité, **caractérisé par le fait que** le plan-mémoire (PM) comprend des cellules-mémoires de référence (CELRj) disposées entre certaines au moins des cellules-mémoires dudit groupe de façon à créer des paquets (PQ) séparés de m cellules-mémoires, chaque cellule-mémoire de référence stockant un bit de référence (dj) programmé à une valeur de référence susceptible d'être modifiée lors d'une attaque par injection de faute et chaque paquet de m cellules-mémoires étant destiné à stocker m bits du bloc associés, lorsque m est supérieur à 1, à des parités différentes, et en ce que les moyens de détection comprennent en outre des deuxièmes moyens de contrôle (CMP1) configurés pour effectuer lors de la lecture dudit bloc, un contrôle de la valeur de chaque bit de référence.

5. Dispositif selon la revendication 4, dans lequel une cellule-mémoire de référence (CELRj) est disposée toutes les m cellules-mémoires.

6. Dispositif selon l'une des revendications 4 à 5, dans lequel le plan-mémoire comprend plusieurs groupes de cellules-mémoires destinés à stocker respectivement plusieurs bloc de bits, chaque bloc de bit ayant le même nombre de bits de données et m bits de parité, toutes les cellules-mémoires (GCEL0) destinées à stocker les bits de même rang des différents blocs étant regroupées au sein d'une même zone (ZM0) du plan-mémoire, et les cellules-mémoires de référence (CELR1) sont disposées entre certaines au moins desdites zones.

7. Circuit intégré comprenant un dispositif de mémoire selon l'une des revendications 4 à 6.

8. Carte à puce comprenant un circuit intégré selon la revendication 7.

## Claims

1. Method of detecting an attack by fault injection on a memory device comprising at least one group of memory cells intended to store at least one block of bits comprising data bits and m parity bits, wherein said detection comprises, when reading a block, a read (30) of each bit of the block contained in the corresponding memory cell and a parity check (37, 38) performed on the basis of the read value of each data bit and the read value of each parity bit, **characterized in that** the method comprises an insertion of reference memory cells (CELR1) between at least some of the memory cells (CELi) of said group so as to create separate packets of m memory cells, a storage in each reference memory cell of a reference bit (dj) programmed with a reference value likely to be modified during an attack by fault injection and a storage, in each packet of m memory cells, of m bits of the block associated, when m is greater than 1, with different parities, and said detection further comprises, when reading said block, a check (39) on the value of each reference bit.

2. Method according to Claim 1, wherein a reference memory cell (CELRj) is inserted every m memory cells.

3. Method according to one of the preceding claims, wherein the memory device comprises a number of groups of memory cells intended to respectively store a number of blocks of bits, each block (BL) of bits having the same number of data bits and m parity bits, all the memory cells (GCELO) intended to store the bits of the same rank of the different blocks being grouped together within one and the same area (ZM0) of the memory plane, and the reference memory cells (CELR1) are inserted between at least some of said areas.

4. Memory device including a memory plane (PM) comprising at least one group of memory cells intended to store at least one block of bits (BL) comprising data bits and m parity bits, and means of detecting an attack by fault injection comprising reading means (ML) configured to read each bit of a block, and first checking means (MCL1, CMPP10, CMPP11) configured to perform, when reading a block, a parity check based on the read value of each data bit and the read value of each parity bit, **characterized by** the fact that the memory plane (PM) comprises reference memory cells (CELRj) arranged between at least some of the memory cells of said group so as to create separate packets (PQ) of m memory cells, each reference memory cell storing a reference bit (dj) programmed with a reference value likely to be modified during an attack by fault injection and each packet of m memory cells being intended to store m bits of the block associated, when m is greater than 1, with different parities, and in that the detection means further comprise second checking means (CMP1) configured to perform, when reading said block, a check on the value of each reference bit.

5. Device according to Claim 4, wherein a reference memory cell (CELRj) is arranged every m memory cells.

6. Device according to one of Claims 4 to 5, wherein the memory plane comprises a number of groups of memory cells intended to respectively store a number of blocks of bits, each block of bits having the same number of data bits and m parity bits, all the memory cells (GCELO) intended to store the bits of the same rank of the different blocks being grouped together within one and the same area (ZM0) of the memory plane, and the reference memory cells (CELR1) are arranged between at least some of said areas.

7. Integrated circuit comprising a memory device according to one of Claims 4 to 6.

8. Chip card comprising an integrated circuit according to Claim 7.

## Patentansprüche

1. Verfahren zur Erfassung eines Angriffs durch Fehlerinjektion auf eine Speichervorrichtung, die mindestens eine Gruppe von Speicherzellen aufweist, die dazu bestimmt sind, mindestens einen Block von Bits zu speichern, der Datenbits und m Paritätsbits enthält, Verfahren, bei dem die Erfassung beim Lesen eines Blocks ein Lesen (30) jedes Bits des Blocks, der in der entsprechenden Speicherzelle enthalten ist, und eine Paritätskontrolle (37, 38) enthält, die ausgehend von dem gelesenen Wert jedes Datenbits und dem gelesenen Wert jedes Paritätsbits durchgeführt wird, **dadurch gekennzeichnet, dass** das Verfahren ein Einfügen von Referenzspeicherzellen (CELR1) zwischen mindestens bestimmte der Speicherzellen (CELi) der Gruppe, um getrennte Pakete von m Speicherzellen zu erzeugen, ein Speichern in jeder Referenzspeicherzelle eines Referenzbits (dj), das auf einen Referenzwert programmiert ist, der bei einem Angriff durch Fehlerinjektion verändert werden kann, und ein Speichern, in jedem Paket von m Speicherzellen, von m Bits des Blocks enthält, die, wenn m größer als 1 ist, verschiedenen Paritäten zugeordnet sind, und die Erfassung außerdem beim Lesen des Blocks eine Kontrolle (39) des Werts jedes Referenzbits enthält.

2. Verfahren nach Anspruch 1, bei dem eine Referenzspeicherzelle (CELRj) alle m Speicherzellen eingefügt wird.

3. Verfahren nach einem der vorhergehenden Ansprüche, bei dem die Speichervorrichtung mehrere Gruppen von Speicherzellen enthält, die dazu bestimmt sind, jeweils mehrere Blöcke von Bits zu speichern, wobei jeder Block (BL) von Bits die gleiche Anzahl von Datenbits und m Paritätsbits aufweist, wobei alle Speicherzellen (GCELO), die dazu bestimmt sind, die Bits gleichen Rangs der verschiedenen Blöcke zu speichern, innerhalb der gleichen Zone (ZM0) der Speicherebene zusammengefasst sind, und die Referenzspeicherzellen (CELR1) zwischen mindestens bestimmte der Zonen eingefügt werden.

4. Speichervorrichtung, die eine Speicherebene (PM) enthält, die mindestens eine Gruppe von Speicherzellen, die dazu bestimmt sind, mindestens einen Block von Bits (BL) zu speichern, der Datenbits und m Paritätsbits aufweist, und Einrichtungen zur Erfassung eines Angriffs durch Fehlerinjektion aufweist, die Leseeinrichtungen (ML), die konfiguriert sind, um jedes Bit eines Blocks zu lesen, und erste Kontrolleinrichtungen (MCL1, CMPP10, CMPP11) enthalten, die konfiguriert sind, um beim Lesen eines Blocks eine Paritätskontrolle ausgehend von dem gelesenen Wert jedes Datenbits und von dem gelesenen Wert jedes Paritätsbits durchzuführen, **dadurch gekennzeichnet, dass** die Speicherebene (PM) Referenzspeicherzellen (CELRj) enthält, die zwischen mindestens bestimmten der Speicherzellen der Gruppe angeordnet sind, um getrennte Pakete (PQ) von m Speicherzellen zu erzeugen, wobei jede Referenzspeicherzelle ein Referenzbit (dj) speichert, das auf einen Referenzwert programmiert ist, der bei einem Angriff durch Fehlerinjektion verändert werden kann, und jedes Paket von m Speicherzellen dazu bestimmt ist, m Bits des Blocks zu speichern, die, wenn m größer als 1 ist, verschiedenen Paritäten zugeordnet sind, und dass die Erfassungseinrichtungen außerdem zweite Kontrolleinrichtungen (CMP1) enthalten, die konfiguriert sind, um beim Lesen des Blocks eine Kontrolle des Werts jedes Referenzbits durchzuführen.

5. Vorrichtung nach Anspruch 4, bei der eine Referenzspeicherzelle (CELRj) alle m Speicherzellen angeordnet ist.

6. Vorrichtung nach einem der Ansprüche 4 bis 5, bei der die Speicherebene mehrere Gruppen von Speicherzellen enthält, die dazu bestimmt sind, jeweils mehrere Blöcke von Bits zu speichern, wobei jeder Block von Bits die gleiche Anzahl von Datenbits und m Paritätsbits aufweist, wobei alle Speicherzellen (GCELO), die dazu bestimmt sind, die Bits gleichen Rangs der verschiedenen Blöcke zu speichern, innerhalb der gleichen Zone (ZM0) der Speicherebene zusammengefasst sind, und die Referenzspeicherzellen (CELR1) zwischen mindestens bestimmten der Zonen angeordnet sind.

7. Integrierter Schaltkreis, der eine Speichervorrichtung nach einem der Ansprüche 4 bis 6 enthält.

8. Chipkarte, die einen integrierten Schaltkreis nach Anspruch 7 enthält.
